(19) **Europäisches Patentamt**
**European Patent Office**
**Office européen des brevets**

(11) **EP 4 745 610 A1**

(12) **EUROPÄISCHE PATENTANMELDUNG**

(43) Veröffentlichungstag:
**20.05.2026 Patentblatt 2026/21**

(21) Anmeldenummer: **24213536.6**

(22) Anmeldetag: **18.11.2024**

(51) Internationale Patentklassifikation (IPC):
**G01R 33/56** (2006.01) **G06N 3/02** (2006.01)
**G06T 7/00** (2017.01)

(52) Gemeinsame Patentklassifikation (CPC):
**G01R 33/5608; G06N 3/02; G06N 3/045;**
**G06N 3/08; G06N 3/084; G06T 7/0002**

(84) Benannte Vertragsstaaten:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Benannte Erstreckungsstaaten:
**BA**
Benannte Validierungsstaaten:
**GE KH MA MD TN**

(71) Anmelder: **Siemens Healthineers AG**
**91301 Forchheim (DE)**

(72) Erfinder: **Zeller, Mario**
**91054 Erlangen (DE)**

(74) Vertreter: **Siemens Healthineers**
**Patent Attorneys**
**Postfach 22 16 34**
**80506 München (DE)**

(54) **COMPUTER-IMPLEMENTIERTES VERFAHREN ZUR AUTOMATISCHEN BEWERTUNG VON BILDDATEN**

(57) Die Erfindung betrifft ein computer-implementiertes Verfahren zur automatischen Bewertung von Bilddaten, insbesondere medizinischen Bilddaten, dahingehend welche Bildqualität mit einer auf die Bilddaten angewandten Bildrekonstruktionsmethode erzielt werden kann, wobei das Verfahren die folgende Verfahrensschritte umfasst: Empfangen und/oder Generieren von zumindest einem Charakterisierungsparameter (2), der ein Signal-zu-Rausch-Verhältnis der Bilddaten charakterisiert; Anwenden eines Evaluationsalgorithmus (6) auf den zumindest einen Charakterisierungsparameter (2), wobei der Evaluationsalgorithmus (6) dazu konfiguriert ist, zumindest ausgehend von dem Charakterisierungsparameter (2) einen Abschätzparameter (22) zu generieren, der die Bildqualität charakterisiert, die mit der Bildrekonstruktionsmethode erzielbar ist, sodass der Abschätzparameter (22) als Bewertung der erzielbaren Bildqualität generiert wird.

FIG 1

EP 4 745 610 A1

**Beschreibung**

Die vorliegende Erfindung betrifft ein computer-implementiertes Verfahren zur automatischen Bewertung von Bilddaten, ein Computerprogrammprodukt und ein medizinisches Bildgebungsgerät.

Unabhängig vom grammatikalischen Geschlecht eines bestimmten Begriffes sind Personen mit männlicher, weiblicher oder anderer Geschlechteridentität mit umfasst.

Es gibt verschiedene Ansätze, um mit Verfahren zur Bildrekonstruktion eine Verbesserung der Bildqualität bei bildgebenden Verfahren, z.B. Magnetresonanz-Verfahren (MR-Verfahren), zu ermöglichen. Insbesondere das Signal-Rausch-Verhältnis (SNR, von engl. "Signal-to-Noise-Ratio") kann durch den Einsatz einer geeigneten Bildrekonstruktionsmethode verbessert werden. Neuere auf Deep-Learning basierende Bildrekonstruktionsmethoden, wie z.B. Deep Resolve Boost (DBR), ermöglichen im Vergleich zu konventionellen Methoden wie GRAPPA (Generalized Autocalibrating Partially Parallel Acquisitions) ein deutlich verbessertes Entrauschungsverhalten. Dadurch kann beispielsweise eine Beschleunigung der Bildaufnahme mit in der Regel dennoch verbesserter Bildqualität ermöglicht werden. Ein Problem beim Einsatz eines Deep-Learning-Verfahrens zur Bildrekonstruktion ist, dass es bei einem sehr geringen Eingangs-SNR nicht wie bei konventionellen Methoden zu einer Rauschverstärkung, sondern oftmals zu einer verstärkten Glättung in den Bilddaten kommt. Dadurch ist das vorhandene Rauschverhalten, z.B. das Fehlen feiner Strukturen, auf den Bilddaten nicht unmittelbar sichtbar und, insbesondere für mit eher klassischen Methoden vertrauten Radiologen, oftmals schwer erkennbar. Aus den so korrigierten (geglätteten) Bilddaten ist nicht direkt ersichtlich, ob bei der verwendeten Geräteeinstellung ein generell zu großes Rauschen auftritt bzw. auftrat. Dies kann die medizinische Diagnose erschweren oder verzerren. Beispielsweise kann durch fehlerhaft gewählte Parameter eine deutliche Reduktion des SNR, z.B. um den Faktor 5, entstehen, wobei dies aufgrund der auftretenden Glättung in den Bilddaten nicht unmittelbar erkennbar ist. Dadurch werden jedoch insbesondere feine Strukturen, die bei geeigneten Parametereinstellungen eindeutig erkennbar wären, verwaschen und nicht mehr klar identifizierbar.

Es ist daher eine Aufgabe der vorliegenden Erfindung, ein Verfahren bereitzustellen, das eine automatische Beurteilung darüber bereitstellt, ob Bilddaten in einer ausreichenden Bildqualität vorliegen und/oder ob gewählte Parametereinstellungen für ein Bildgebungsverfahren geeignet gewählt sind. Insbesondere wäre es wünschenswert, eine Möglichkeit zu haben, die Auswahl eines geeigneten SNR-Niveaus beim Einstellen von Scanparametern zu unterstützen.

Diese Aufgabe wird gelöst mit einem Verfahren gemäß Anspruch 1, einem Computerprogrammprodukt gemäß Anspruch 14 und einem medizinischen Bildgebungsgerät gemäß Anspruch 15.

Erfindungsgemäß ist ein computer-implementiertes Verfahren zur automatischen Bewertung von Bilddaten, insbesondere medizinischen Bilddaten, dahingehend welche Bildqualität mit einer auf die Bilddaten angewandten Bildrekonstruktionsmethode erzielt werden kann, vorgesehen, wobei das Verfahren die folgende Verfahrensschritte umfasst: Empfangen und/oder Generieren von zumindest einem Charakterisierungsparameter der ein Signal-zu-Rausch-Verhältnis der Bilddaten charakterisiert; Anwenden eines Evaluationsalgorithmus auf den zumindest einen Charakterisierungsparameter, wobei der Evaluationsalgorithmus dazu konfiguriert ist, ausgehend von dem zumindest einen Charakterisierungsparameter zumindest einen Abschätzparameter zu generieren, der die Bildqualität charakterisiert, die mit der Bildrekonstruktionsmethode erzielbar ist, sodass der zumindest eine Abschätzparameter als Bewertung der erzielbaren Bildqualität generiert wird.

Medizinische Daten müssen insbesondere in den Bereichen der MR-Verfahren und der Computertomografie präzise und korrekt auswertbar sein, wozu die korrekte Anwendung einer auf die Aufnahme der Bilddaten folgenden Bildrekonstruktionsmethode und ein korrektes Verständnis der rekonstruierten Bilder von großer Bedeutung ist. Unter einer Bildrekonstruktionsmethode wird allgemein eine Methode verstanden, mit der Bild-Rohdaten, beispielsweise MR-Rohdaten im k-Raum, in den Bildbereich zu überführen, das heißt tatsächliche Bilder zu erzeugen. Bildrekonstruktionsmethoden, insbesondere im Rahmen der MR-Bildgebung, sind im Stand der Technik generell bekannt. Vorteilhafterweise ermöglicht es das erfindungsgemäße Verfahren, die sich aus der Bildrekonstruktionsmethode ergebenden Bilddaten bezüglich ihrer Bildqualität bzw. zu erwartenden Bildqualität zu bewerten, sodass ein Benutzer eine Rückmeldung darüber erhält, inwiefern er mit den Bilddaten überhaupt brauchbare Daten erhalten hat oder erhalten kann, beispielsweise ob eingestellte Einstellparameter eines Scans richtig gewählt worden sind. Beispielsweise kann es vorgesehen sein, bereits vor einer Messung vorhersagen zu können, ob die Messung überhaupt sinnvoll ist.

Ein besonders relevanter Parameter für die erzielbare Bildqualität stellt das Signal-zu-Rausch-Verhältnis (SNR) dar. Das Signal-zu-Rausch-Verhältnis kann auch als SNR bezeichnet werden und wird im Rahmen dieser Erfindung gelegentlich derart abgekürzt. In einem ersten Verfahrensschritt wird der zumindest eine Charakterisierungsparameter empfangen und/oder generiert. Der Charakterisierungsparameter ist allgemein ein Parameter der mit dem SNR zusammenhängt bzw. aus dem das SNR abgeleitet werden kann. Der zumindest eine Charakterisierungsparameter kann beispielsweise das SNR sein. Es kann vorgesehen sein, dass das SNR als ein Charakterisierungsparameter in das Verfahren eingespeist wird. Der zumindest eine Charakterisierungsparameter muss jedoch nicht unbedingt das SNR direkt sein. Beispielsweise kann ein Charakterisierungsparameter proportional zu dem SNR sein. Es kann vorgesehen sein, dass der zumindest eine Charakterisierungsparameter, insbesondere mehrere Charakterisierungsparameter, dazu geeignet ist/sind, dass daraus das SNR berechnet bzw. hergeleitet wird.

Der Evaluationsalgorithmus wird auf den zumindest einen Charakterisierungsparametern, beispielsweise auf ein SNR, angewendet, wodurch ein Ausgangswert, nämlich der Abschätzparameter, generiert wird, über den die Bildqualität der Bilddaten abgeschätzt wird. Unter einem Evaluationsalgorithmus kann allgemein ein Algorithmus verstanden werden, der eine Auswertung oder Bewertung basierend auf Eingangsdaten ermöglicht. In diesem Fall ist der zumindest eine Charakterisierungsparameter die Eingabe für den Evaluationsalgorithmus. Der Evaluationsalgorithmus kann insbesondere mit Hilfe einer vorab durchgeführten Verknüpfung von Charakterisierungsparametern und einer jeweils zugehörigen Bildqualität konfiguriert sein, den Abschätzparameter zu generieren. Der Abschätzparameter ist allgemein ein Maß für die Bildqualität, die mit den Bilddaten und der Bildrekonstruktionsmethode erzielt werden kann. Der Abschätzparameter kann ein numerischer Wert sein. Beispielsweise kann der Abschätzparameter ein Wert auf einer Bewertungsskala sein. Der Abschätzparameter kann optional eine wörtlich ausformulierte Bewertung sein oder Grundlage für eine wörtlich ausformulierte Bewertung sein. Eine wörtlich ausformulierte Bewertung kann beispielsweise "Bildqualität ausreichend" oder "Bildqualität ungenügend" sein. In einem weiteren Schritt ist es insbesondere vorgesehen, dass eine Meldung an einen Nutzer ausgegeben wird, die den Abschätzparameter oder eine Nachricht, die auf dem Abschätzparameter basiert, umfasst. Beispielsweise kann der Abschätzparameter ein numerischer Wert sein, auf dessen Grundlage eine wörtlich ausformulierte Bewertung ausgegeben wird. Der Abschätzparameter kann dem Benutzer als Orientierungshilfe dienen, ob seine eingestellten Scan-Parameter geeignet für eine beabsichtigte Diagnose sind/waren. Dies ist insbesondere vorteilhaft, um diagnostischen Fehlern vorzubeugen. Der Abschätzparameter kann spezielle Informationen über die Bildqualität umfassen. Beispielsweise kann der Abschätzparameter eine Information über eine erwartbare Verschmierung der Bilddaten, insbesondere bemessen in Pixeln und/oder Voxeln. Beispielsweise kann der Abschätzparameter selbst oder eine darauf basierende Meldung die folgenden Varianten umfassen: "Mit den gewählten Einstellungen ist eine mittlere Verschmierung um 1,1 Pixel und eine maximale Verschmierung um 1,5 Pixel zu erwarten", "Mit den gewählten Einstellungen ist eine mittlere Verschmierung um 1,4 Pixel und eine maximale Verschmierung um 2,5 Pixel zu erwarten. Achtung: Schmale Strukturen sind mit diesen Einstellungen möglicherweise nicht mehr sichtbar".

Der Begriff Bildqualität ist insbesondere hinsichtlich eines informativen, insbesondere diagnostischen, Werts der Bilddaten zu verstehen. Ein informativer Wert der Bilddaten kann insbesondere den Informationsgehalt der Bilddaten bezeichnen. Beispielsweise kann die Bildqualität einen Detailgrad umfassen, der in den Bilddaten enthalten ist. Relevant kann beispielsweise sein, ob bestimmte Strukturen, beispielsweise ein Organ oder ein Krankheitsmerkmal eines Organs, grundsätzlich erkennbar sind. Ist das SNR zu niedrig, können viele Strukturen gar nicht mehr erkennbar sein, was mit einer niedrigen Bildqualität assoziiert sein kann. Durch den Abschätzparameter kann festgestellt werden, ob die Bildqualität für einen vorgesehen Zweck der Bilddaten ausreichend ist. Das computer-implementiertes Verfahren liefert damit ein simpel einsetzbares Bewertungstool, das für verschiedene Bildgebungsverfahren und unterschiedliche Rekonstruktionsmethoden angewendet werden kann. Auch die Charakterisierungsparameter als Input-Werte können gegebenenfalls je nach Bildgebungsverfahren und Rekonstruktionsmethoden variiert werden.

Gemäß einer Ausführungsform basiert die zu bewertende Bildrekonstruktionsmethode auf einem trainierten neuronalen Netz (NN), insbesondere auf einem Deep-Learning-basierten neuronalen Netz. Im Gegensatz zu konventionellen Methoden liefern Rekonstruktionsmethoden, die auf trainierten neuronalen Netzen basieren, effektiv schnelle und klare Bilddaten und sind daher in Hinblick auf die steigende Nachfrage nach bildgebungsbasierenden Untersuchungen beispielsweise in der Medizin von hoher Bedeutung, da über die neuronalen Netze schnell große Datenmengen verarbeitet werden können. Es kann eine im Stand der Technik bekannte NNbasierte Bildrekonstruktionsmethode vorgesehen sein. Wie eingangs beschrieben ist das SNR insbesondere bei auf neuronalen Netzen basierenden Bildrekonstruktionsmethoden problematisch, da ein zu schlechtes SNR oftmals in den fertigen Bildern nicht mehr unmittelbar erkennbar ist und somit eine schlechte Bildqualität oftmals nur schwer bzw. nicht eindeutig erkennbar ist. Das Verfahren löst dieses Problem, indem es eine Möglichkeit bietet, die tatsächlich erzielbare Bildqualität über den Abschätzparameter zu bestimmen. Das erfindungsgemäße Verfahren kann daher besonders vorteilhaft bei NN-basierten Bildrekonstruktionsmethoden angewendet werden. Eine Anwendung des Verfahrens kann insbesondere auch bei konventionellen iterativen Rekonstruktionsverfahren, wie z.B. Compressed Sensing, besonders vorteilhaft sein. Konventionelle iterative Rekonstruktionsverfahren, wie z.B. Compressed Sensing, sind typischerweise ebenfalls von dieser Problematik betroffen.

Gemäß einer Ausführungsform basiert der zumindest eine Charakterisierungsparameter auf zumindest einem Protokollparameterwert und/oder auf einer Messmethode, insbesondere unter Verwendung der Bilddaten und/oder weiterer Bilddaten. Die Charakterisierungsparameter können aus Protokollparameterwerten resultieren, die im Wesentlichen durch das zugehörige Bildgebungsverfahren gegeben sind. Beispielsweise kann der zumindest eine Charakterisierungsparameter aus dem zumindest einen Protokollparameterwerte abgeleitet werden. Der zumindest eine Charakterisierungsparameter kann selbst zumindest ein Protokollparameterwert sein. Der zumindest eine Charakterisierungsparameter kann über die Messmethode, optional über das Bildgebungsfahren messtechnisch erfasst werden. Das Ableiten des zumindest einen Charakterisierungsparameters aus dem zumindest einen Protokollparameterwerte ist vorteilhaft einsetzbar, da es eine theoretische Abschätzung und/oder Berechnung ist, die zeiteffizient und/oder kostengünstig erfolgen kann. Das kann besonders vorteilhaft sein, wenn sich eine Messung mit dem bildgebenden System finanziell sehr aufwendig und zeitintensiv gestaltet. Zumindest ein auf einer Messmethode basierender Charakterisierungsparameter kann eine besonders präzisere und mit relativ wenigen Annahmen behaftete Bestimmung des Abschätzparameters ermöglichen, insbesondere da die Charakterisierungsdaten direkt auf die Messdaten eines bestimmten Gerätetyps eines Bildgebungsverfahrens zurückzuführen sein können.

Gemäß einer Ausführungsform sind die Bilddaten Magnetresonanztomographie-Bilddaten, wobei der zumindest eine Protokollparameterwert eines oder mehrere umfasst aus: eine Feldstärke eines Hauptmagneten des Magnetresonanztomographiesystems, eine eingestellte Voxelgröße, eine eingestellte Anzahl an Mittelungen, eine eingestellte Anzahl an Phasenkodierschritten, ein Beschleunigungsfaktor einer parallelen Bildgebung, eine verwendete Fettsättigungstechnik. Die Magnetresonanztomographie ist mit eines der am häufigsten eingesetzten Bildgebungsverfahren. Aufgrund der hohen Betriebskosten der MRT-Geräte ist es von Vorteil die Charakterisierungsparameter, insbesondere das SNR, über verschiedene Protokollparameter zu bestimmen. Zu den entscheidendsten Faktoren, die das reale SNR während der Messung beeinflusst, zählt das B0-Feld des Hauptmagneten, das direkt im proportionalen Verhältnis zum SNR stehen kann. Ebenso beeinflusst die voreingestellte Voxelgröße das SNR, wobei diese hinreichend groß eingestellt werden sollte, um ein zu geringes SNR zu vermeiden. Bei größeren Voxeln tragen mehr Protonen zum Signal bei, wodurch sich das SNR in der Regel proportional zur Voxelgröße verhält. Andere relevante Faktoren, die sich auf das SNR auswirken können sind eingestellte Anzahl an Mittelungen, die eingestellte Anzahl an Phasenkodierschritten, ein Beschleunigungsfaktor einer parallelen Bildgebung und eine verwendete Fettsättigungstechnik. Die SNR kann durch mehrfache Messungen einer Schicht, d.h. mehrere Akquisitionen und entsprechende Mittelungen, verbessert werden. Die Anzahl der gemessenen und in einer Schicht gemittelten Akquisitionen wird als Anzahl der Mittelungen bezeichnet. Die Anzahl der Phasenkodierschritte entspricht der Anzahl der angewandten unterschiedlichen Phasenkodierungen. Die SNR ist typischerweise proportional zur Wurzel der Anzahl der Mitteilungen und der Wurzel der Anzahl der Phasenkodierschritte. Wird die Anzahl der Mittelungen oder der Phasenkodierschritte verringert, verringert sich auch die Messzeit, weshalb Nutzer oftmals versuchen, durch Verringern dieser Anzahlen schnellere Messungen zu ermöglichen. Ein zu starkes Verringern dieser Anzahlen kann jedoch für ein zu geringes SNR sorgen. Die Anzahl der Mitteilungen und der Phasenkodierschritte sollte daher ähnlich wie die Voxelgröße so eingestellt werden, dass das SNR groß genug ist. Im Stand der Technik ist die Möglichkeit bekannt durch parallele Akquisitionstechniken mit mehreren Empfängern, insbesondere mehreren Spulenelementen, die gleichzeitig verwendet werden, die Messzeiten zu verringern. Die damit erzielbare Beschleunigung wird durch den Beschleunigungsfaktor angegeben. Jedoch ist das SNR typischerweise antiproportional zur Wurzel des Beschleunigungsfaktors, verringert sich also bei größerem Beschleunigungsfaktor. Um zu erreichen, dass das Fettgewebe nicht die Sicht auf die eigentlich zu detektierenden Merkmale verhindert, werden Fettsättigungstechniken verwendet, beispielsweise indem Radiofrequenzpulse verwendet werden, um das Fettsignal zu unterdrücken. Dadurch wird jedoch in der Regel auch das eigentliche Signal verringert, weshalb auch die verwendete Fettsättigungstechnik Einfluss auf das SNR hat. Es ist daher vorteilhaft die Fettsättigungstechnik als bzw. für den zumindest einen Charakterisierungsparameter zu berücksichtigen. Zusätzlich oder alternative kann optional einer oder mehrere weiterer Protokollparameter umfasst sein, wie z.B. der Sequenztyp und/oder der Flipwinkel, die sich gegebenenfalls auf das SNR auswirken können.

Gemäß einer Ausführungsform wird zumindest einer des zumindest einen Charakterisierungsparameters formelbasiert mit einer mathematischen Formel berechnet, wobei die Formel den zumindest einen Protokollparameterwert umfasst. Die Formel kann insbesondere die Feldstärke eines Hauptmagneten des Magnetresonanztomographiesystems, die eingestellte Voxelgröße, die eingestellte Anzahl an Mittelungen, die eingestellte Anzahl an Phasenkodierschritten, den Beschleunigungsfaktor einer parallelen Bildgebung, und/oder die verwendete Fettsättigungstechnik umfassen. Die Komplexität der Einflussgrößen auf das SNR bewirkt, dass es nahezu unmöglich ist, alle Einflussgrößen bei der Abschätzung zu berücksichtigten, insbesondere dadurch, dass die Zuordnung der Wertepaare von Charakterisierungs- und Abschätzparameter immer mehr Dimensionen annehmen würde. Es kann vorgesehen sein, dass die Formel eine Auswahl an Protokollparameterwerten umfasst, die Einfluss auf das Signal-zu-Rausch-Verhältnis haben. Insbesondere kann eine Abschätzformel verwendet werden, die (insbesondere nur) die für das Signal-zu-Rausch-Verhältnis relevantesten Protokollparameter berücksichtigt. Beispielsweise kann eine Formel der folgenden Form verwendet werden:

$$SNR \propto \frac{B_0 * V * \sqrt{N} * \sqrt{PE} * f}{\sqrt{R}}$$

Diese Formel zeigt den direkten proportionalen Zusammenhang zwischen dem SNR und der Feldstärke des Hauptmagneten $B_0$, der Voxelgröße V, der Anzahl der Mitteilungen N, der Phasenkodierschritte PE und der verwendete Fettsättigungstechnik f. Der empirisch gewählte Faktor der Fettsättigung kann insbesondere in einem Intervall zwischen 0,3 bis 09,99, vorzugsweise 0,5 und 0,95, besonders bevorzugt zwischen 0,7 und 0,9 liegen. Sollte eine parallele Bildgebung R verwendet werden, geht diese ebenfalls in die Abschätzung des SNR ein. Durch die simple Handhabe der Abschätzformel ist es möglich, auf einfache Weise einen Charakterisierungsparameter zu erstellen. Insbesondere kann es mit einer Formel auch möglich sein, wenn ein trainierter Algorithmus, insbesondere ein neuronales Netz, für den Evaluationsalgorithmus verwendet wird, auf relativ einfache Weise eine große Vielzahl von Wertepaaren zu generieren, mit denen der trainierte Algorithmus trainiert werden kann.

Gemäß einer Ausführungsform basiert die Messmethode auf einem Rausch-Scan ohne Anregungspuls und/oder umfasst ein mehrmaliges Messen derselben k-Raum-Linien und eine Ermittlung eines Mittelwerts und/oder einer Standardabweichung davon und/oder das Bilden eines Verhältnisses aus Daten des k-Raum-Randes zu einem k-Raum-Zentrum. Die messtechnische Bestimmung der Abschätzparameter erfolgt insbesondere mit dem jeweils zum Bildgebungsverfahren gehörigem Gerät und ist zwar typischerweise zeitintensiver als die formelbasierte Abschätzung, kann allerdings gerätespezifisch oftmals besonders präzise Output-Werte liefern. Um beispielsweise für Trainingszwecke möglichst eine große Anzahl von Wertepaaren von Charakterisierungs- und Abschätzparametern zu generieren, können Mehrfachmessungen durchgeführt werden, aus denen ein Mittelwert und eine Standardabweichung für Messungen mit gleichen Protokollparametereinstellungen gebildet wird. Zur Bestimmung des zumindest einen Charakterisierungsparameters und/oder des SNR gibt es verschiedene Möglichkeiten. Eine Möglichkeit ist es, einen reinen Rausch-Scan ohne Anregungsimpuls durchzuführen, sodass nur das Rauschen detektiert wird. Die Standardabweichung des Rausches kann beispielsweise mit einem im k-Raum aufgenommenen Signal ins Verhältnis gesetzt werden. Vorteil dieser Methode ist die verhältnismäßig leichte Durchführbarkeit. Eine weitere Option ist durch die Analyse des k-Raums gegeben. Die detektierten k-Raum-Rand-Linien können insbesondere als stellvertretend für ein Rauschen interpretiert werden. Die zentralen k-Raum-Linien können als stellvertretend für ein Signal interpretiert werden. Die k-Raum-Rand-Linien können mit den zentralen k-Raum-Linien in ein Verhältnis gesetzt werden, sodass daraus ein Maß für die SNR ermittelt werden kann. Damit ist eine Bestimmung des SNR möglich, insbesondere ohne, dass weitere Daten gemessen werden müssen, denn es können die ohnehin im Rahmen der Hauptmessung aufgenommenen Bilddaten herangezogen werden. Das mehrmalige Messen derselben k-Raum-Linien und eine Ermittlung eines Mittelwerts und/oder einer Standardabweichung kann ein besonders präzises Abschätzen des SNR ermöglichen. Beispielsweise kann davon ausgegangen werden das das SNR proportional zu einem Verhältnis aus Mittelwert und Standardabweichung ist.

Gemäß einer Ausführungsform ist der zumindest eine Charakterisierungsparameter das Signal-zu-Rausch-Verhältnis, wobei das Signal-Rausch-Verhältnis optional anhand eines Entscheidungsbaums und/oder einer Lookup-Tabelle abgeschätzt wird. Vorteilhafterweise können ein Entscheidungsbaum und/oder einer Lookup-Tabelle eine besonders einfache Möglichkeit darstellen das Signal-zu-Rausch-Verhältnis zu bestimmen. Beispielsweise können berechnete Wertepaare in Form einer Lookup-Tabelle und/oder eines Entscheidungsbaums zusammengefasst werden. Optional kann eine manuelle Bestimmung des Signal-zu-Rausch-Verhältnisses vorgesehen sein. Eingabe kann beispielsweise zumindest ein Messparameterwert sein, anhand dessen das SNR bestimmt wird.

Gemäß einer Ausführungsform ist der Evaluationsalgorithmus dazu ausgestaltet, den Abschätzparameter aus dem Charakterisierungsparameter basierend auf einer Serie von verknüpften vorbestimmten Charakterisierungsparametern und vorbestimmten Abschätzparametern zu generieren. Der Evaluationsalgorithmus, kann beispielsweise dazu konfiguriert sein, bei Eingabe des zumindest einen Charakterisierungsparameters, beispielsweise eines SNRs, einen zugehörigen Abschätzparameter auszugeben. Dieser Abschätzparameter kann insbesondere ein qualitativer Wert sein, der bewertet, ob eine Einstellung gemäß dem zumindest einen Charakterisierungsparameter für eine vorgesehene bzw. zugehörige Bildrekonstruktionsmethode geeignet ist. Beispielsweise kann somit ermittelt werden, ob die Messung des Bildgebungsverfahrens mit anderen Parametern durchgeführt werden sollte oder, sofern sie bereits durchgeführt wurde, wiederholt werden sollte.

Gemäß einer Ausführungsform sind die vorbestimmten Abschätzparameter basierend auf dem Anwenden einer pixelweisen Störung in einem Satz von Beispielbilddaten erzeugt worden, wobei insbesondere jeweils die vorbestimmten Abschätzparameter auf einer Punktspreizfunktion des Vergleichs je eines rekonstruierten Beispielbildes mit und ohne die Störung basiert. Beispielbilddaten sind allgemein vorab bereitgestellte Bilddaten, die ähnlich denjenigen Bilddaten sind, für die das Verfahren dann angewandt werden soll. Insbesondere können die Beispielbilddaten mit einem gleichen Bildgebungssystem aufgenommen worden sein, oder eine Simulation einer entsprechenden Aufnahme sein. Vorteilhafterweise kann mit dieser Ausführungsform besonders zuverlässig automatisiert aus dem Charakterisierungsparameter auf den Abschätzparameter geschlossen werden. Das Verwenden einer pixelweisen Störung und das Verwenden von Punktspreizfunktionen, um eine Qualität abzuschätzen kann insbesondere auf einem Verfahren basieren, das von Kleineisel et al. 2023 in "Assessment of resolution and noise in magnetic resonance images reconstructed by data driven approaches", Zeitschrift für Medizinische Physik, DOI: 10.1016/j.zemedi.2023.08.007, beschrieben wurde. Dabei wird für jeden Pixel eines Bildes eine minimale Störung eingeführt, sodass ein störungsbehaftetes rekonstruiertes Referenzbild entsteht, von dem das Originalbild subtrahiert wird, sodass im Ergebnis nur die Störungen übrigbleiben, die als Punktspreizfunktionen dargestellt werden können. Das Ausmaß dieser Punktspreizfunktionen, insbesondere die Breite des Peaks erlaubt eine Quantifizierung der Verschmierung bzw. des Rauschens und damit eine Bestimmung des SNR in Abhängigkeit der zugehörigen Charakterisierungsparameter. Beispielsweise kann die Breite des Peaks mit Hilfe der FWHM (d.h. Halbwertsbreite - engl.: "Full Width at Half Maximum") definiert werden. Mit anderen Worten kann der Abschätzparameter die FWHM umfassen. Optional kann der zumindest eine Abschätzparameter eine mittlere FWHM und eine maximale FWHM umfassen. Die mittlere FWHM kann die mittlere FWHM der FWHM mehrerer Bildzeilen der Bilddaten sein. Die maximale FWHM kann die maximale FWHM der FWHM der mehreren Bildzeilen der Bilddaten sein. Es hat sich gezeigt, dass dieses Prinzip der pixelweisen Störung sehr gut im Rahmen dieser Erfindung Anwendung finden kann, indem mit Hilfe dieses Verfahrens Charakterisierungsparameter mit Abschätzparametern verknüpft werden. Es kann optional vorgesehen sein, dass ein kleiner Bildausschnitt der Bilddaten, auf den diese Methode angewendet wird, ausgewählt wird. Vorteilhafterweise kann somit Zeit eingespart werden. Alternativ oder zusätzlich kann es vorgesehen sein, gezielt Testpunkte und/oder nur Pixel, die oberhalb eines festdefinierten Schwellwerts liegen, der Bilddaten auszuwählen und darauf die pixelweise Störung anzuwenden. Es kann vorgesehen sein, die pixelweisen Störung für unterschiedliche Rauschlevel anzuwenden. Damit kann vorteilhafterweise eine verbesserte und exaktere Verknüpfung der Charakterisierungsparameter mit den, insbesondere aus den Punktspreizfunktionen bestimmten, Abschätzparametern ermöglicht werden.

Gemäß einer Ausführungsform sind die vorbestimmten Abschätzparameter basierend auf jeweils zumindest einem konventionell rekonstruierten Bild, vorzugsweise basierend auf jeweils zumindest zwei konventionell rekonstruierten Bildern des gleichen Gegenstandes, und basierend auf einem Signal-zu-Rausch-Verhältnis des zumindest einen konventionell rekonstruierten Bildes bestimmt. Mit anderen Worten kann somit ein für das SNR charakteristischer abgeschätzter Charakterisierungsparameter mit dem tatsächlich in einem rekonstruierten Bild auftretenden SNR (Abschätzparameter) verknüpft werden. Ein konventionell rekonstruiertes Bild ist insbesondere ein Bild, das mit einer nicht auf Deep-Learning-Methoden basierenden Bildrekonstruktionsmethode rekonstruiert wurde und/oder dass mit einer Rekonstruktionsmethode rekonstruiert wurde, bei der verrauschte Eingangsdaten auch zu einem Rauschen in dem rekonstruierten Bild führen. Ein Beispiel für eine konventionelle Rekonstruktionsmethode in diesem Sinne ist GRAPPA. Zwei konventionell rekonstruierte Bilder des gleichen Gegenstandes sind zwei Bilder die auf zwei verschiedenen, beispielsweise aufeinanderfolgenden, Messungen des gleichen Gegenstandes basieren. Die zwei verschiedenen Messungen können insbesondere mit den gleichen Messparametern aufgenommen werden. Der gleiche Gegenstand bedeutet dabei, dass das gleiche Motiv bzw. das gleiche Objekt und/oder Subjekt, insbesondere auf gleiche Weise, aufgenommen wurde. Beispielsweise kann zweimal die gleiche Stelle eines Organs eines Patienten aus der gleichen Perspektive aufgenommen werden. Das Signal-zu-Rausch-Verhältnis kann aus zwei konventionell rekonstruierten Bildern des gleichen Gegenstandes bestimmten werden, indem beispielsweise ein Verhältnis aus einem Mittelwert der beiden Bilder und einer Standardabweichung der Differenz der beiden Bilder in zumindest einer Region der beiden Bilder, optional in mehreren Regionen und/oder für die gesamten Bilder, bestimmt wird. Mit einer einzelnen Messung kann das Signal-zu-Rausch-Verhältnis beispielsweise bestimmt werden, indem mehrmals ein Rauschen mit je gleicher Stärker aber unterschiedlicher zufälliger Verteilung künstlich vor dem Rekonstruieren aufaddiert wird und dann für jedes Bild mit verschiedenem aufaddierten Rauschen eine konventionelle Bildrekonstruktion durchführt, um somit mehrere konventionell rekonstruierte Bilder des gleichen Gegenstandes zu erhalten.

Alternativ kann auch eine einmalige Messung erfolgen und dann eine oftmalige Rekonstruktion mit verschiedenem aufaddiertem Rauschen identischer Stärke aber zufälliger Verteilung auf die Daten erfolgen. Aus diesen Informationen kann insbesondere eine pixelgenaue Abschätzung der Rauschverstärkung erfolgen. Eine solche pixelgenaue Abschätzung kann analog nach im Stand der Technik bekannten Methoden erfolgen, wie beispielswiese beschrieben in Robson, P.M., Grant, A.K., Madhuranthakam, A.J., Lattanzi, R., Sodickson, D.K. and McKenzie, C.A. (2008), Comprehensive quantification of signal-to-noise ratio and g-factor for image-based and k-space-based parallel imaging reconstructions. Magn. Reson. Med., 60: 895-907. https://doi.org/10.1002/mrm.21728.

Gemäß einer Ausführungsform sind die vorbestimmten Charakterisierungsparameter mit den vorbestimmten Abschätzparametern jeweils der gleichen Beispielbilddaten verknüpft. Die Beispielbilddaten können auf diese Weise verwendet werden, um den Evaluationsalgorithmus zu konfigurieren. Insbesondere kann somit sichergestellt werden, dass die vorbestimmten Charakterisierungsparameter und die vorbestimmten Abschätzparameter tatsächlich einander entsprechen bzw. einander zuzuordnen sind. Die Beispielbilddaten können optional zumindest teilweise synthetisch erzeugt sein bzw. werden. Beispielsweise können bestehende Beispieldaten erweitert werden, indem ein Rauschen auf die Beispieldaten aufaddiert wird, um weitere Beispieldaten zu erzeugen. Beispielsweise kann ein Gauß'sches Rauschen aufaddiert werden. Vorteilhafterweise können somit aus ursprünglich relativ wenigen Beispieldaten größere Mengen an Beispieldaten erzeugt werden. Mit Hilfe des aufaddierten Rauschens kann das SNR beeinflusst werden. Beispielsweise kann ein Satz von Beispielbilddaten herangezogen werden und für alle Beispielbilddaten wird jeweils der zumindest eine Charakterisierungsparameter und der Abschätzparameter bestimmt. Somit kann vorteilhafterweise auf relativ einfache Weise ein Satz von zusammengehörenden vorbestimmten Charakterisierungsparametern und Abschätzparametern bestimmt werden.

Gemäß einer Ausführungsform sind die vorbestimmten Abschätzparameter zumindest teilweise manuell, insbesondere mithilfe einer Likert-Skala, mit den vorbestimmten Charakterisierungsparametern verknüpft worden. Eine manuelle Variante kann eine besonders einfache Lösung sein, um die vorbestimmten Abschätzparameter zu erhalten, sofern ein geeigneter Fachmann Einschätzung der Abschätzparameter zur Verfügung stellt. In diesem Fall eignet sich insbesondere die Likert-Skala als manuell einsetzbares Bewertungstool. Eine Likert-Skala ermöglicht insbesondere eine qualitative Aussage über die Bildqualität zu erfassen. Im vorliegenden Verfahren kann von einem Experten beispielsweise über die Likert-Skala die Aussage abgefragt werden, ob eine Bildqualität eines Beispielbildes für eine bestimmten Zweck, z.B. eine medizinische Analyse, ausreichend ist. Beispielsweise kann der Experte anhand der Likert-Skala eine Qualitätsbeurteilung der Art "ausreichende Bildqualität" "ungenügende Bildqualität" machen. Optional können weitere Abstufungen vorgesehen sein. Beispielsweise können die Abstufungen "ausreichende Qualität", "ausreichende und gute Qualität" etc. vorgesehen sein. Beispielsweise kann die Likert-Skala einen Anwendungszweckbezug umfassen. Insbesondere können Abstufungen der Likert-Skala für verschiedene Typen Bild-bezogener Diagnosen vorgesehen sein. Beispielsweise können Abstufungen der Likert-Skala von dem Typ "generell ungenügende Bildqualität", "für Diagnose A ausreichende Bildqualität", "für Diagnose B ausreichende Bildqualität" sein.

Gemäß einer Ausführungsform generiert der Evaluationsalgorithmus den Abschätzparameter anhand einer Abschätzparameter-Lookup-Tabelle basierend auf der Serie, wobei in der Abschätzparameter-Look-Up-Tabelle jeweils zumindest ein Charakterisierungsparameter oder ein Bereich von Charakterisierungsparametern jeweils einem Abschätzparameter zugeordnet ist, gemäß einem Entscheidungsbaum oder gemäß einer Abschätzformel. Basierend auf diesen hinterlegten Wertepaaren, kann bei Anwendung des Evaluationsalgorithmus einem eingehenden Charakterisierungswert automatisch ein Abschätzparameter zugeordnet werden, der dem Benutzer eine Rückmeldung über die Bildqualität liefert. Vorteilhafterweise kann dabei dem Benutzer eine eindeutige Aussage übermittelt werden. Insbesondere kann vorgesehen sein, dass auch bei Eingabe einer Kombination mehrerer Charakterisierungsparametern nur ein Abschätzparameter ausgegeben wird. Der Entscheidungsbaums und/oder die Lookup-Tabelle kann/können beispielsweise in dem Evaluationsalgorithmus abgespeichert sein und/oder der Evaluationsalgorithmus kann Zugriff darauf haben. Der Entscheidungsbaum kann beispielsweise auf der Abfrage bzw. Überprüfung mehrerer Charakterisierungsparameter basieren, die insbesondere nacheinander geprüft werden. Beispielsweise kann zunächst geprüft werden, welchen Wert ein erster Charakterisierungsparameter aufweist und darauf basierend können verschiedene Anforderungen an die Werte weiterer Charakterisierungsparameter gestellt werden. Beispielsweise kann zunächst geprüft werden, wie groß eine Feldstärke des Hauptmagneten ist (z.B. 1,5 T oder 3 T der 7 T) und darauf basierend können verschiedene Mindestanforderungen an die Anzahl der Mittelungen oder die Anzahl der Phasenkodierschritte gestellt werden, die dann ebenfalls geprüft werden. Der Entscheidungsbaum kann mehrere Wege zu einem positiven Abschätzparameter und/oder mehrere Wege zu einem negativen Abschätzparameter aufweisen. Die Lookup-Tabelle kann beispielsweise bestimmte Werte von Charakterisierungsparametern mit bestimmten Werten von Abschätzparametern verknüpfen. Beispielsweise können SNR-Werte unterhalb einer Grenzschwelle mit einem negativen Abschätzparameter verknüpft sein. Vorteilhafterweise können ein Entscheidungsbaum und/oder einer Lookup-Tabelle eine besonders einfache Möglichkeit darstellen, den Evaluationsalgorithmus umzusetzen, sofern entsprechende Daten vorhanden sind. Mit der Abschätzformel können insbesondere proportionale Zusammenhänge zwischen den Charakterisierungsparametern, insbesondere dem SNR, und einem Abschätzparameter, insbesondere einer Ausweitung von Verschmierungen in den Bilddaten, die in den Punktspreizfunktionen dargestellt werden, ermittelt werden. Die Abschätzformel kann insbesondere eine Proportionalitätsformel sein. Auf der Basis einer oder mehrerer Proportionalitätsformeln kann beispielsweise eine Benutzermeldungen anhand von Schwellwerten erstellt werden. Die Schwellwerte können beispielsweise eine Verschmierung in eine minimale, mittlere und maximale Verschmierung einteilen. Die Abschätzformel kann beispielsweise die Form $FWHM\_mean(x) = ax^2 + bx + cx^{1/2} + d$ aufweisen, wobei x der Charakterisierungsparameter, insbesondere ein SNR, und a, b, c, d Faktoren sind. Die Faktoren können insbesondere im Rahmen eines klassischen Fittings der vorbestimmten Abschätzparameter und vorbestimmten Charakterisierungsparameter (jeweils wie hierin beschrieben) ermittelt werden.

Gemäß einer Ausführungsform umfasst der Evaluationsalgorithmus einen trainierten Algorithmus, insbesondere ein trainiertes neuronales Netz, wobei der trainierte Algorithmus dazu konfiguriert ist, aus einer Eingabe des zumindest einen Charakterisierungsparameters den Abschätzparameter als Ausgabe zu generieren, wobei der trainierte Algorithmus insbesondere anhand der Serie von verknüpften vorbestimmten Charakterisierungsparametern und vorbestimmten Abschätzparametern wie hierin beschrieben trainiert ist. Der trainierte Algorithmus basiert insbesondere auf maschinellem Lernen. Generell kann ein auf maschinellem Lernen basierter trainierter Algorithmus so verstanden werden, dass er kognitive Funktionen, die im Allgemeinen mit dem menschlichen Verstand assoziiert werden können, imitiert. Insbesondere ist ein auf maschinellem Lernen basierter Algorithmus durch Training basierend auf Trainingsdaten in der Lage, sich bestimmten bzw. neuen Gegebenheiten anzupassen und Muster zu erkennen sowie zu extrapolieren. Ein auf maschinellem Lernen basierter trainierter Algorithmus kann auch als trainierte Funktion oder trainiertes Modell bezeichnet werden. Im Allgemeinen können Parameter des auf maschinellem Lernen basierten Algorithmus durch Training angepasst werden. Insbesondere können die Parameter des Algorithmus iterativ durch mehrere Trainingsschritte angepasst werden. Beispielsweise kann während des Trainings eine bestimmte Verlustfunktion optimiert, insbesondere minimiert, werden. Insbesondere kann der trainierte Algorithmus ein neuronales Netz (NN) sein. Das neuronale Netz kann auch als künstliches neuronales Netz (KNN), künstliches neuronales Netzwerk oder künstliches neuronales Netzwerk bezeichnet werden. Für die Zwecke dieser Erfindung kann ein strukturell relativ einfach aufgebautes Neuronales Netz vorgesehen sein. Insbesondere kann ein neuronales Netz mit einer Eingabeschicht, einer Ausgabeschicht und zumindest einer verborgenen Schicht vorgesehen sein. Beispielsweise können 1 bis 5, vorzugsweise 1 bis 3, verborgene Schichten vorgesehen sein. Beispielsweise kann das neuronale Netz 2 verborgene Sichten umfassen. Die Eingabeschicht kann eine oder mehrere künstliche Neuronen, insbesondere ein künstliches Neuron pro vorgesehenem Charakterisierungsparameter, aufweisen. Die Ausgabeschicht kann eine oder mehrere künstliche Neuronen umfassen. Die verborgenen Schichten umfassen vorzugsweise jeweils mehrere künstliche Neuronen, besonders bevorzugt mehr künstliche Neuronen als die Eingabeschicht. Beispielsweise können die verborgenen Schichten 2 bis 10, vorzugsweise 2 bis 6 künstliche Neuronen umfassen. Die künstlichen Neuronen der verborgenen Schichten können Rectifier ("Gleichrichter") als Aktivierungsfunktion umfassen. Entsprechende Einheiten mit einem Rectifier werden typischerweise als ReLu (Rectified Linear Unit) bezeichnet. In einer einfachen Variante kann der trainierte Algorithmus dazu trainiert sein, eine binäre Ausgabe, wie zum Beispiel "gut" oder "schlecht" auszugeben. Optional kann der trainierte Algorithmus dazu trainiert sein, zumindest einen kontinuierlichen Wert als Ausgabemöglichkeit zu haben. Die Ausgabewert kann direkt an einen Nutzer weitergegeben werden oder es kann eine Meldung basierend auf dem Ausgabewert an einen Nutzer weitergegeben werden. Ist beispielsweise die Ausgabe des trainierten Algorithmus ein kontinuierlicher Wert, kann in Abhängigkeit von dem kontinuierlichen Wert z.B. eine Textnachricht ausgegeben werden.

Zum Trainieren des Algorithmus, insbesondere des neuronalen Netzes, können vorbestimmte Charakterisierungsparameter als Eingangstrainingsdaten und vorbestimmte Abschätzparameter als Ausgangstrainingsdaten (auch als "Ground Truth" bezeichnet) verwendet werden. Beispielsweise können die Eingangstrainingsdaten dazu auf eine reelle Zahl zwischen 0 und 1 normalisiert werden. Beispielsweise kann ein SNR mit Grenzwerten zwischen 0 und 250 auf das Intervall zwischen 0 und 1 transformiert werden. Die Menge an verwendeten Trainingsdaten kann von der Anzahl an trainierbaren Parametern abhängig gemacht werden. Für eine Netzarchitektur wie hierin beispielsweise beschrieben können für das erfindungsgemäße Verfahren wenige hundert Trainingsdatensätze ausreichend sein. Während des Trainings kann der Algorithmus bzw. das NN auf die Eingangstrainingsdaten angewandt werden, um Ausgabewerte zu generieren. Die Ausgabewerte können beispielsweise einen oder mehrere Zahlen, optional auf einer kontinuierlichen Skala, umfassen. Die Anzahl der Zahlen der Ausgabewerte entspricht insbesondere der Anzahl der künstlichen Neuronen der Ausgabeschicht. Durch einen Vergleich der Ausgabewerte mit den Ausgangstrainingsdaten können Gewichte des Algorithmus bzw. NN rekursiv angepasst werden. Vorteilhafterweise ist es mit den Trainingsdaten möglich, Zusammenhänge, beispielsweise proportionale Zusammenhänge, zwischen den Charakterisierungsparametern, insbesondere dem SNR, und einer Ausweitung von Verschmierungen in den Bilddaten, die in den Punktspreizfunktionen dargestellt werden, zu ermitteln.

Ein weiterer Aspekt der Erfindung ist ein Computerprogrammprodukt, umfassend Befehle, die bei deren Ausführung durch einen Computer und/oder durch eine Steuervorrichtung eines medizinischen Bildgebungsgeräts diesen/diese veranlassen, die Schritte des Verfahrens gemäß einem der vorhergehenden Ansprüche auszuführen. Das Computerprogrammprodukt kann die Grundlage liefern, das Computer-implementierte Verfahren zur automatischen Bildbewertung auszuführen. Alle Merkmale und Vorteile des Verfahrens zur Bewertung der Bildqualität können dementsprechend auf das Computerprogrammprodukt und/oder die Steuervorrichtung des medizinischen Bildgebungsgeräts übertragen werden und gegebenenfalls entsprechend angepasst werden. Das Computerprogrammprodukt kann beispielsweise auf einem computerlesbaren Speichermedium, insbesondere nichtflüchtigen Speichermedium, gespeichert sein. Das Speichermedium kann beispielsweise eine Festplatte, eine SSD, ein Flash-Speicher, ein Online-Server, etc., sein.

Ein weiterer Aspekt ist ein medizinisches Bildgebungsgerät, insbesondere Magnetresonanztomographiegerät, umfassend ein Steuervorrichtung, die dazu ausgestaltet ist, ein Verfahren wie hierin beschrieben auszuführen. Allgemein kann das computer-implementierte Verfahren zur automatischen Bildbewertung für verschiedene Bildgebungsverfahren mit unterschiedlichen Bildrekonstruktionsmethoden angewendet werden. Alle Merkmale und Vorteile des Verfahrens zur Bewertung der Bildqualität können auf das Bildgebungsgerät übertragen werden und gegebenenfalls entsprechend angepasst werden.

Weitere Vorteile und charakteristische Merkmale der vorliegenden Erfindung ergeben sich aus der nachfolgenden Beschreibung mit Bezug auf die beigefügten Figuren. Gleiche Merkmale werden in den Figuren jeweils mit gleichen Bezugszeichen verwendet, auch wenn sie Teil unterschiedlicher Ausführungsform sind. Es versteht sich dabei, dass einzelne Merkmale, welche nur für eine bestimmte Ausführungsform explizit beschrieben werden, auch in anderen Ausführungsform der Erfindung zum Einsatz gelangen können sollen, sofern sich diese nicht aufgrund technischer Gegebenheiten verbietet.

Es zeigen:

Fig.1    ein Ablaufdiagramm eines computer-implementierten Verfahrens zur automatischen Bewertung von Bilddaten gemäß einer Ausführungsform der Erfindung,

Fig. 2    ein Ablaufdiagramm einer Ausführungsform des Verfahrensschritts a) der vorliegenden Erfindung,

Fig. 3    ein Ablaufdiagramm einer Ausführungsform des Trainings eines neuronalen Netzes gemäß einer Ausführungsform der vorliegenden Erfindung,

Fig. 4    ein künstliches neuronales Netz gemäß einer Ausführungsform der Erfindung und

Fig. 5    ein medizinisches Bildgebungsgerät 7 gemäß einer Ausführungsform der Erfindung.

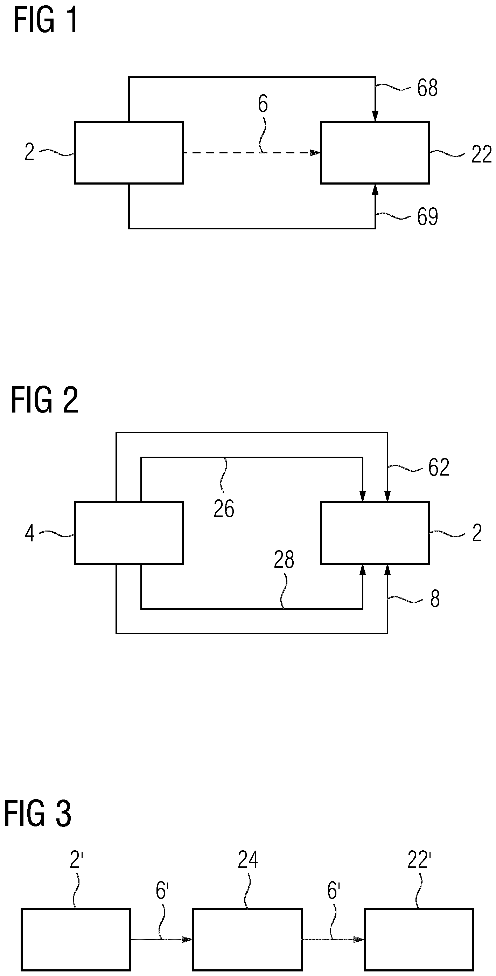

Die Figur 1 zeigt ein Ablaufdiagramm eines computer-implementierten Verfahrens zur automatischen Bewertung von Bilddaten gemäß einer Ausführungsform der Erfindung. Dabei werden die Charakterisierungsparameter 2, insbesondere das SNR, als Eingangsparameter in den auf einem neuronalen Netz basierenden, trainierten Evaluationsalgorithmus 6 eingespeist, der durch Anwenden hinterlegter Trainingsdaten den zu den Eingangsparameter zuordbaren Ausgangswert, den Abschätzwert 22, ausgibt. Dieser Abschätzwert 22 bewertet qualitativ die Bildqualität der Bilddaten, die auf Basis der Charakterisierungsdaten 2 aufgenommen und mittels einer Bildrekonstruktionsmethode korrigiert wurden oder werden sollen. Die Verknüpfung der Charakterisierungsparameter und der Abschätzparameter kann beispielsweise über eine Likert-Skala 68 und/oder einer Lookup-Tabelle 69 erfolgen.

Die Figur 2 zeigt ein Ablaufdiagramm einer Ausführungsform des Verfahrensschritts a) der vorliegenden Erfindung. In dem Verfahrensschritt a) werden die Charakterisierungsdaten 2, insbesondere das SNR, mittels verschiedener Protokollparameter 4 generiert. Die Protokollparameter stellen daher insbesondere Einstellungsparameter des Bildgebungsverfahrens dar. Bei der Magnetresonanztomographie wirken sich insbesondere die Feldstärke des Hauptmagneten, die eingestellte Voxelgröße, die eingestellte Anzahl an Mittelungen, die eingestellte Anzahl an Phasenkodierschritten, der Beschleunigungsfaktor einer parallelen Bildgebung sowie die verwendete Fettsättigungstechnik auf das SNR aus. Entsprechend können die hierfür verwendeten Protokollparameter 4 insbesondere einige oder alle dieser Werte umfassen. Die Zuordnung des SNR als Charakterisierungsparameter 2 zu den eingehenden Protokollparametern 4 kann sowohl formelbasiert, messtechnisch als auch manuell erfolgen. Die formelbasierte Abschätzung wird mittels einer mathematischen Formel 8 durchgeführt, die insbesondere die (Anti-)Proportionalität der Protokollparameter 4 zu dem SNR beschreibt. Typischerweise steht der Beschleunigungsfaktor einer parallelen Bildgebung in einem antiproportionalen Zusammenhang zu dem SNR. Das SNR oder ein damit zusammenhängender Wert kann auch messtechnisch ermittelt werden. Beispielsweise kann die Messmethode 62 entweder aus einem Rausch-Scan ohne Anregungsimpuls bestehen oder durch die Detektion verschiedener k-Raum-Linien, die sich entweder am k-Raum-Rand, entsprechend eines Rauschens, oder im k-Raum-Zentrum, entsprechend des Signals, befinden und in ein Verhältnis zueinander gesetzt werden. Bei Einsatz einer Messmethode 62 erfolgen die Messungen vorzugsweise mehrfach und auf unterschiedlichen Rauschniveaus, sodass die Charakterisierungsparameter als Mittelwerte gebildet werden können. Alternativ können den eingehenden Protokollparametern die Charakterisierungsparameter auch manuell durch die Verwendung einer ersten Lookup-Tabelle 28 oder eines Entscheidungsbaums 28 zugeordnet werden.

Die Figur 3 zeigt ein Ablaufdiagramm einer Ausführungsform des Trainings des trainierten Algorithmus bzw. neuronalen Netzes gemäß einer Ausführungsform der vorliegenden Erfindung. Der trainierte Algorithmus bzw. Das neuronale Netz, auf dem der Evaluationsalgorithmus 6 in dieser Ausführungsform basiert, wird mit vorbestimmten Charakterisierungsparametern 2' und vorbestimmten Abschätzparametern 22' trainiert, um bei Anwendung des Verfahrens die eingehenden Charakterisierungsparameter 2 mit den zugehörigen Abschätzparametern 22 verknüpfen zu können. Die Trainingsdaten setzen sich somit zusammen aus den vorbestimmten Charakterisierungsparametern 2' und den vorbestimmten Abschätzparametern 22'. Die für das Training verwendeten vorbestimmten Abschätzparameter 22' können beispielsweise basierend auf dem Einführen einer pixelweisen Störung bestimmt bzw. generiert werden. Dieses Verfahren basierend auf einer pixelweisen Störung kann entsprechend wie von Kleineisel et al. 2023 beschrieben durchgeführt werden, wobei durch das Anwenden einer pixelweisen Störung 6' in einem Satz von Beispielbilddaten vorbestimmte Abschätzparameter 22' erzeugt werden, wobei diese auf einer Punktspreizfunktion 24 des Vergleichs je eines rekonstruierten Beispielbildes mit und ohne die Störung basieren. Die Randbereiche der Punktspreizfunktionen 24 stellen das Rauschverhalten dar, während das Zentrum das Signal zeigt. So kann über die Punktspreizfunktionen 24 das Maß der Verschmierung des Signals ermittelt werden. Zum Trainieren des Algorithmus bzw. des neuronalen Netzes können die vorbestimmten Charakterisierungsparameter und die vorbestimmten Abschätzparameter als Wertepaare bereitgestellt werden, wobei verschiedene Wertepaare insbesondere auf verschiedenen Rauschniveaus und/oder verschiedenen eingesetzten Protokollparametern basieren.

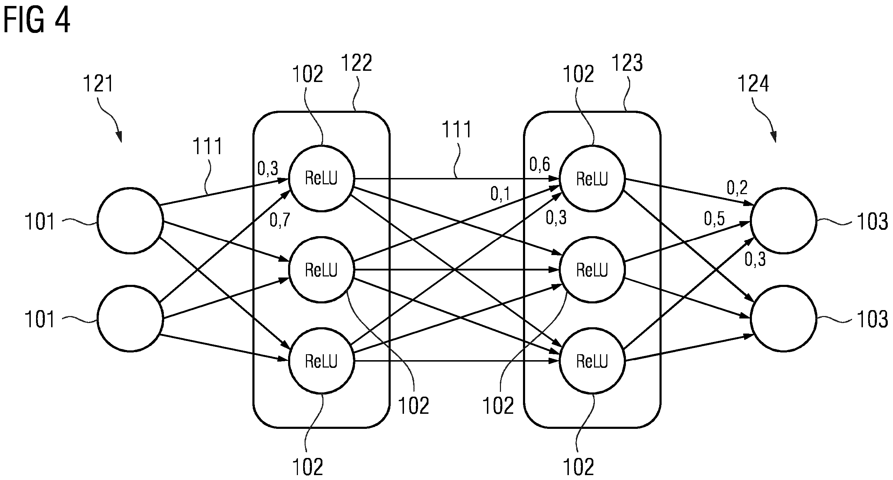

Die Figur 4 zeigt ein (künstliches) neuronales Netz gemäß einer Ausführungsform der Erfindung. Das neuronale Netz umfasst künstliche Neuronen 101, 102, 103 und Verbindungen 111 zwischen den künstlichen Neuronen 101, 102, 103. Jede Verbindung ist eine gerichtete Verknüpfung von einem ersten künstlichen Neuron 101, 102 zu einem weiteren künstlichen Neuron 102, 103. Die verschiedenen künstlichen Neuronen 101, 102, 103 unterscheiden sich im Allgemeinen, können jedoch auch identisch sein. Die künstlichen Neuronen 101, 102, 103 sind in Schichten 121, 122, 123, 124 angeordnet, die untereinander eine Reihenfolge aufweisen, die sich über die Verbindungen 111 ergibt. Hierbei gibt es ein Eingabeschicht 121, eine Ausgabeschicht 124 und zwei versteckte Schichten 122, 123 zwischen der Eingabeschicht 121 und der Ausgabeschicht 124. Die Anzahl der künstlichen Neuron 101 der Eingabeschicht 121 entspricht insbesondere der Anzahl der Eingabewerte, in diesem Fall insbesondere der Anzahl der Charakterisierungsparameter 2. Die Anzahl der künstlichen Neuron 103 der Ausgabeschicht 124 entspricht insbesondere der Anzahl der Ausgabewerte, in diesem Fall insbesondere der Anzahl der Abschätzparameter 22. Insbesondere kann jedem künstlichen Neuron 101, 102, 103 eine reelle Zahl zugeordnet werden. Dabei entsprechen die Werte der künstlichen Neuronen 101 der Eingabeschicht 121 den Eingabewerten bzw. den Charakterisierungsparametern 2 und die Werte der künstlichen Neuronen 103 der Ausgabeschicht 124 entsprechen den Ausgabewerten bzw. den Abschätzparametern 22. Den Verbindungen 111 werden ebenfalls reelle Zahlen, insbesondere im Intervall zwischen 0 und 1, zugeordnet, die als Gewichte bezeichnet werden. Diese Gewichte werden typischerweise im Rahmen des Trainings angepasst. Einige Beispielwerte (0,3 - 0,7 - 0,6 - 0,1 - 0,3 - 0,2 - 0,5 - 0,3) für Gewichte der Verbindungen sind hier eingezeichnet. Um die Ausgabewerte zu bestimmen, propagieren die Eingabewerte durch das neuronale Netz, wobei jeweils die Werte ($x^{(n+1)}_j$) der jeweiligen künstlichen Neuronen 102, 103 (j) der jeweils nächsten Schicht (n + 1) basierend auf den Werten ($x^{(n)}_i$) der künstlichen Neuronen 101, 102 (i) der jeweils vorherigen Schicht (n) gewichtet durch die Gewichte ($w^{(n)}_{i,j}$) der Verbindungen 111 berechnet werden. Dies kann beispielsweise gemäß der Formel

$$x^{(n+1)}_j = f\left(\sum_i x^{(n)}_i \times w^{(n)}_{i,j}\right)$$

vorgesehen, wobei $f$ eine Aktivierungsfunktion ist, die in dem Fall der versteckten Schichten in dieser Ausführungsform jeweils ein Rectifier ("ReLU") ist. Alternative Funktionen könnten beispielsweise Stufenfunktionen oder Sigmoidfunktionen sein. Der Rectifier kann insbesondere gemäß dem Term $f(x) = \max(0, x)$ vorgesehen sein, mit dem Eingangswert x des jeweiligen künstlichen Neurons. Die Eingangswerte bzw. Charakterisierungsparameter können beispielswese eine mittels einer Formel berechnete SNR und das Ergebnis eine Rauschmessung bzw. ein auf einer Rauschmessung basierender SNR oder eine auf einer Rauschmessung basierender Rauschwert sein. Aber auch alternative Eingabewerte sind denkbar. Beispielsweise könnten die zwei Eingabewerte ein Mittelwert und eine Standardabweichung einer Rauschmessung sein. Es ist auch möglich eine andere Zahl von Eingabewerten vorzusehen, beispielsweise könnte genau ein SNR vorgesehen sein, oder es könnten mehrere Protokollparameterwerte jeweils als Eingabewerte vorgesehen sein, beispielsweise 5 oder sechs Protokollparameterwerte. Die Ausgabewerte können beispielsweise eine mittlere FWHM und eine maximale FWHM sein. Es sind jedoch auch andere Ausgabewerte und andere Anzahlen von Ausgabewerten (z.B. genau ein Ausgabewert oder mehr als drei Ausgabewerte) denkbar.

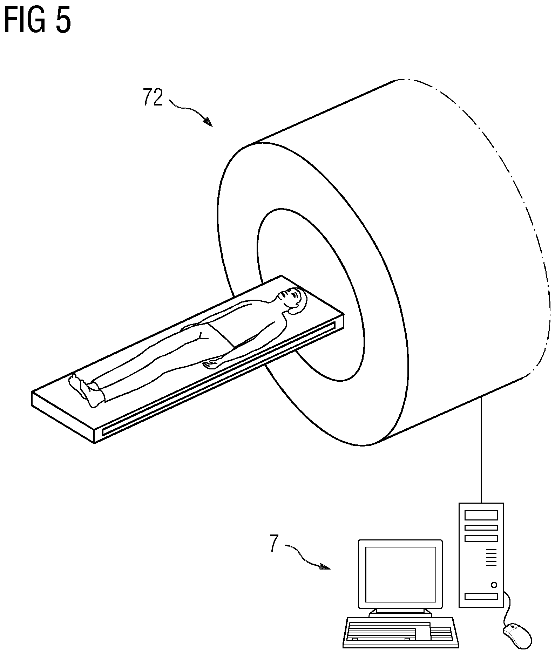

Die Figur 5 zeigt ein medizinisches Bildgebungsgerät 72 gemäß einer Ausführungsform der Erfindung, in der ein Magnetresonanztomographiegerät mit einer Steuervorrichtung, die in einen Computer 7 integriert ist, verbunden ist. Über den Computer 7 läuft das Computer-implementierte Verfahren zur automatischen Bewertung von Bilddaten der vorliegenden Erfindung ab, wobei der Computer 7 bzw. die Steuervorrichtung dem Verfahren entsprechende Befehle ausführt und dem Benutzer eine Meldung über die Qualität der aufgenommenen Bilddaten ausgibt. Insbesondere kann ein SNR von Bilddaten, die mit einer Bildrekonstruktionsmethode rekonstruiert werden, anhand der Verschmierung der Pixel der Bilddaten stufenweise in nicht, minimal, mittel und maximal ausreichend eingestuft werden. Zur Definition der Abstufung können entsprechende Schwellwerte eingesetzt werden.

**Patentansprüche**

1.  Computer-implementiertes Verfahren zur automatischen Bewertung von Bilddaten, insbesondere medizinischen Bilddaten, dahingehend welche Bildqualität mit einer auf die Bilddaten angewandten Bildrekonstruktionsmethode erzielt werden kann, wobei das Verfahren die folgende Verfahrensschritte umfasst:

    a) Empfangen und/oder Generieren von zumindest einem Charakterisierungsparameter (2), der ein Signal-zu-Rausch-Verhältnis der Bilddaten charakterisiert;
    b) Anwenden eines Evaluationsalgorithmus (6) auf den zumindest einen Charakterisierungsparameter (2), wobei der Evaluationsalgorithmus (6) dazu konfiguriert ist, ausgehend von dem zumindest einen Charakterisierungsparameter (2) zumindest einen Abschätzparameter (22) zu generieren, der die Bildqualität charakterisiert, die mit der Bildrekonstruktionsmethode erzielbar ist, sodass der zumindest eine Abschätzparameter (22) als Bewertung der erzielbaren Bildqualität generiert wird.

2.  Verfahren gemäß Anspruch 1, wobei die zu bewertende Bildrekonstruktionsmethode auf einem trainierten neuronalen Netz basiert, insbesondere auf einem Deep-Learning-basierten neuronalen Netz.

3.  Verfahren gemäß einem der vorhergehenden Ansprüche, wobei der zumindest eine Charakterisierungsparameter (2) auf zumindest einem Protokollparameterwert (4) und/oder auf einer Messmethode (62), insbesondere unter Verwendung der Bilddaten und/oder weiterer Bilddaten, basiert.

4.  Verfahren gemäß Anspruch 3, wobei die Bilddaten Magnetresonanztomographie-Bilddaten sind, wobei der zumindest eine Protokollparameterwert (4) eines oder mehrere umfasst aus: eine Feldstärke eines Hauptmagneten des Magnetresonanztomographiesystems, eine eingestellte Voxelgröße, eine eingestellte Anzahl an Mittelungen, eine eingestellte Anzahl an Phasenkodierschritten, ein Beschleunigungsfaktor einer parallelen Bildgebung, eine verwendete Fettsättigungstechnik.

5.  Verfahren gemäß Anspruch 3 oder 4, wobei zumindest einer des zumindest einen Charakterisierungsparameters (2) formelbasiert mit einer mathematischen Formel (8) berechnet wird, wobei die Formel den zumindest einen Protokollparameterwert (4) umfasst.

6.  Verfahren gemäß einem der Ansprüche 3 bis 5, wobei die Messmethode (62) auf einem Rausch-Scan ohne Anregungspuls basiert und/oder, wobei die Messmethode (62) ein mehrmaliges Messen derselben k-Raum-Linien und eine Ermittlung eines Mittelwerts und/oder einer Standardabweichung davon umfasst und/oder, wobei die Messmethode (62) das Bilden eines Verhältnisses aus Daten des k-Raum-Randes zu einem k-Raum-Zentrum umfasst.

7.  Verfahren gemäß einem der vorhergehenden Ansprüche, wobei der Evaluationsalgorithmus (6) dazu ausgestaltet ist, den Abschätzparameter (22) aus dem Charakterisierungsparameter (2) basierend auf einer Serie von verknüpften vorbestimmten Charakterisierungsparametern (2) und vorbestimmten Abschätzparametern (22) zu generieren.

8.  Verfahren gemäß Anspruch 7, wobei die vorbestimmten Abschätzparameter (22') basierend auf dem Anwenden einer pixelweisen Störung (6') in einem Satz von Beispielbilddaten erzeugt worden sind, wobei insbesondere jeweils die vorbestimmten Abschätzparameter (22') auf einer Punktspreizfunktion (24) des Vergleichs je eines rekonstruierten Beispielbildes mit und ohne die Störung basiert.

9.  Verfahren gemäß Anspruch 7 oder 8, wobei die vorbestimmten Abschätzparameter basierend auf jeweils zumindest einem konventionell rekonstruierten Bild, vorzugsweise basierend auf jeweils zumindest zwei konventionell rekonstruierten Bildern des gleichen Gegenstandes, und basierend auf einem Signal-zu-Rausch-Verhältnis des zumindest einen konventionell rekonstruierten Bildes bestimmt sind.

10. Verfahren gemäß einem der Ansprüche 7 bis 9, wobei die vorbestimmten Charakterisierungsparameter (2) mit den vorbestimmten Abschätzparametern (22) jeweils der gleichen Beispielbilddaten verknüpft sind.

11. Verfahren gemäß einem der Ansprüche 7 bis 10,

wobei die vorbestimmten Abschätzparameter (22) zumindest teilweise manuell, insbesondere mithilfe einer Likert-Skala (68), mit den vorbestimmten Charakterisierungsparametern (2) verknüpft worden sind.

12. Verfahren gemäß einem der Ansprüche 8 bis 11, wobei der Evaluationsalgorithmus (6) den Abschätzparameter (22) anhand einer Abschätzparameter-Lookup-Tabelle basierend auf der Serie generiert, wobei in der Abschätzparameter-Lookup-Tabelle jeweils zumindest ein Charakterisierungsparameter (2) oder ein Bereich von Charakterisierungsparametern (2) jeweils einem Abschätzparameter (22) zugeordnet ist, gemäß einem Entscheidungsbaum und/oder gemäß einer Abschätzformel.

13. Verfahren gemäß einem der vorhergehenden Ansprüche,

wobei der Evaluationsalgorithmus (6) einen trainierten Algorithmus, insbesondere ein trainiertes neuronales Netz umfasst,
wobei der trainierte Algorithmus dazu konfiguriert ist, aus einer Eingabe des zumindest einen Charakterisierungsparameters (2) den Abschätzparameter (22) als Ausgabe zu generieren, wobei der trainierte Algorithmus insbesondere anhand der Serie gemäß Anspruch 8 trainiert ist.

14. Computerprogrammprodukt, umfassend Befehle, die bei deren Ausführung durch einen Computer (7) und/oder durch eine Steuervorrichtung eines medizinischen Bildgebungsgeräts (72) diesen/diese veranlassen, die Schritte des Verfahrens gemäß einem der vorhergehenden Ansprüche auszuführen.

15. Medizinisches Bildgebungsgerät (72), insbesondere Magnetresonanztomographiegerät, umfassend ein Steuervorrichtung, die dazu ausgestaltet ist, ein Verfahren gemäß einem der Ansprüche 1 bis 13 auszuführen.

## FIG 1

## FIG 2

## FIG 3

FIG 4

FIG 5

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | KLEINEISEL JONAS ET AL: "Assessment of resolution and noise in magnetic resonance images reconstructed by data driven approaches", ZEITSCHRIFT FUR MEDIZINISCHE PHYSIK, 9. September 2023 (2023-09-09), XP093266893, DE ISSN: 0939-3889, DOI: 10.1016/j.zemedi.2023.08.007 * das ganze Dokument * ----- | 1-12,14, 15 | INV. G01R33/56 G06N3/02 G06T7/00 |
| X | WO 2019/141651 A1 (KONINKLIJKE PHILIPS NV [NL]) 25. Juli 2019 (2019-07-25) * das ganze Dokument * ----- | 1-4,7-15 | |
| X | US 11 257 191 B2 (GE PREC HEALTHCARE LLC [US]) 22. Februar 2022 (2022-02-22) * das ganze Dokument * ----- | 1-4,7-15 | |
| A | SHANSHAN WANG ET AL: "Knowledge-driven deep learning for fast MR imaging: Undersampled MR image reconstruction from supervised to un-supervised learning", MAGNETIC RESONANCE IN MEDICINE, WILEY-LISS, US, Bd. 92, Nr. 2, 16. April 2024 (2024-04-16) , Seiten 496-518, XP072643773, ISSN: 0740-3194, DOI: 10.1002/MRM.30105 * das ganze Dokument * ----- | 1-15 | RECHERCHIERTE SACHGEBIETE (IPC) G01R G06N G06T |

Der vorliegende Recherchenbericht wurde für alle Patentansprüche erstellt

| Recherchenort | Abschlußdatum der Recherche | Prüfer |
|---|---|---|
| München | 4. April 2025 | Durst, Markus |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

 ........................................................................

& : Mitglied der gleichen Patentfamilie, übereinstimmendes Dokument

EPO FORM 1503 03.82 (P04C03)

**EP 4 745 610 A1**

**ANHANG ZUM EUROPÄISCHEN RECHERCHENBERICHT
ÜBER DIE EUROPÄISCHE PATENTANMELDUNG NR.**          EP 24 21 3536

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-04-2025

| Im Recherchenbericht angeführtes Patentdokument | Datum der Veröffentlichung | Mitglied(er) der Patentfamilie | Datum der Veröffentlichung |
|---|---|---|---|
| WO 2019141651 A1 | 25-07-2019 | CN 111630572 A | 04-09-2020 |
| | | EP 3743890 A1 | 02-12-2020 |
| | | US 2020388058 A1 | 10-12-2020 |
| | | WO 2019141651 A1 | 25-07-2019 |
| US 11257191 B2 | 22-02-2022 | CN 112396560 A | 23-02-2021 |
| | | EP 3779866 A1 | 17-02-2021 |
| | | US 2021049743 A1 | 18-02-2021 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **VON KLEINEISEL et al.** Assessment of resolution and noise in magnetic resonance images reconstructed by data driven approaches. *Zeitschrift für Medizinische Physik*, 2023

- **ROBSON, P.M** ; **GRANT, A.K** ; **MADHURANTHAKAM, A.J.** ; **LATTANZI, R** ; **SODICKSON, D.K.** ; **MCKENZIE, C.A**. Comprehensive quantification of signal-to-noise ratio and g-factor for image-based and k-space-based parallel imaging reconstructions.. *Magn. Reson. Med.*, 2008, vol. 60, 895-907, https://doi.org/10.1002/mrm.21728